(19) Europäisches Patentamt
European Patent Office
Office européen des brevets

(11) EP 0 553 547 B1

## (12) EUROPEAN PATENT SPECIFICATION

(45) Date of publication and mention
of the grant of the patent:
**06.05.1999 Bulletin 1999/18**

(51) Int Cl.6: **G11C 11/407**, G11C 7/00

(21) Application number: **92309983.2**

(22) Date of filing: **30.10.1992**

(54) **Strobe signals in semiconductor memory devices**

Stroboskopische Signale in Halbleiterspeicheranordnungen

Signaux stroboscopiques pour dispositifs de mémoire à semi-conducteurs

(84) Designated Contracting States:
**DE FR GB IT**

(30) Priority: **31.01.1992 KR 146192**

(43) Date of publication of application:
**04.08.1993 Bulletin 1993/31**

(73) Proprietor: **SAMSUNG ELECTRONICS CO. LTD.**
**Suwon-city, Kyounggi-do 441-742 (KR)**

(72) Inventors:
- **Choi, Yun-Ho**
  **Kwonsun-ku, Suwon city, Kyungki-do (KR)**
- **Haq, Ejaz UI**
  **Seoul (KR)**
- **Chin, Dae-je**
  **Seoul (KR)**
- **Cho, Soo-In**
  **Seoul (KR)**

(74) Representative: **Stanley, David William et al**
**DIBB LUPTON**
**BROOMHEAD**
**117 The Headrow, Leeds LS1 5JX (GB)**

(56) References cited:
- **DATABUS no. 2, February 1985, DEVENTER NL pages 28 - 31 TERLINGEN 'NIBBLE MODE: EEN TREND IN DYNAMISCHE RAM'S'**
- **IBM TECHNICAL DISCLOSURE BULLETIN. vol. 32, no. 8A, January 1990, NEW YORK US pages 438 - 440 'MULTIPLE WORDLINE CONTROL SCHEME FOR DRAM WITH SINGLE RAS INPUT'**
- **EDN ELECTRICAL DESIGN NEWS vol. 34, no. 8, April 1989, NEWTON, MASSACHUSETTS US pages 157 - 164 WAWRZYNEK 'TAILOR MEMORY SYSTEM ARCHITECTURE FOR YOUR CHOSEN DRAM'**

**Description**

The present invention relates to semiconductor memory devices, and more particularly to dynamic random access memories.

The progress of semiconductor memory devices has brought a high degree of the integration, and the demand for high speed access of a signal has become strong. Generally, high speed operation of a chip means that the accessing of cell data stored in a memory array from the exterior of the chip by the control of a central processing unit (CPU) of a system is performed at high speed. Generally, in a DRAM, a data access operation is performed by synchronizing a system clock generated in the system. As the speed of the system clock is increased, the data access operation of the chip should be performed with a speed corresponding to the speed of the system clock. It is known in the art that the speed of the system clock has been proposed up to 66MHz (which means that a pulse period of the system clock is 15 nano-seconds (ns)), and this will become faster in future. The data access operation of the chip must be performed with a speed corresponding to the system clock speed. However, the data access operation of the chip does not tend to keep up with the processing speed of the system with the construction of current semiconductor memory devices.

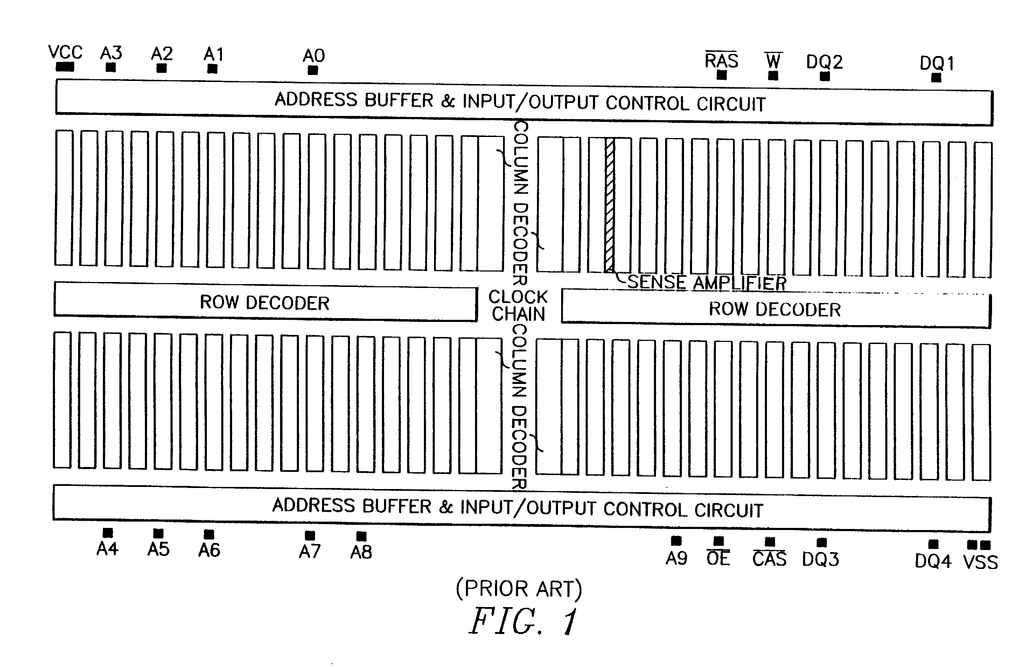

Figure 1 of the accompanying diagrammatic drawings shows the construction of a general DRAM chip. An array construction of Figure 1 is divided into four memory arrays each having a number of sub-arrays. Moreover, the array construction may be changed according to the degree of integration of the chip. Data in each sub-array is accessed by the control of the system, and the control of the system is executed through pins at the exterior of the array.

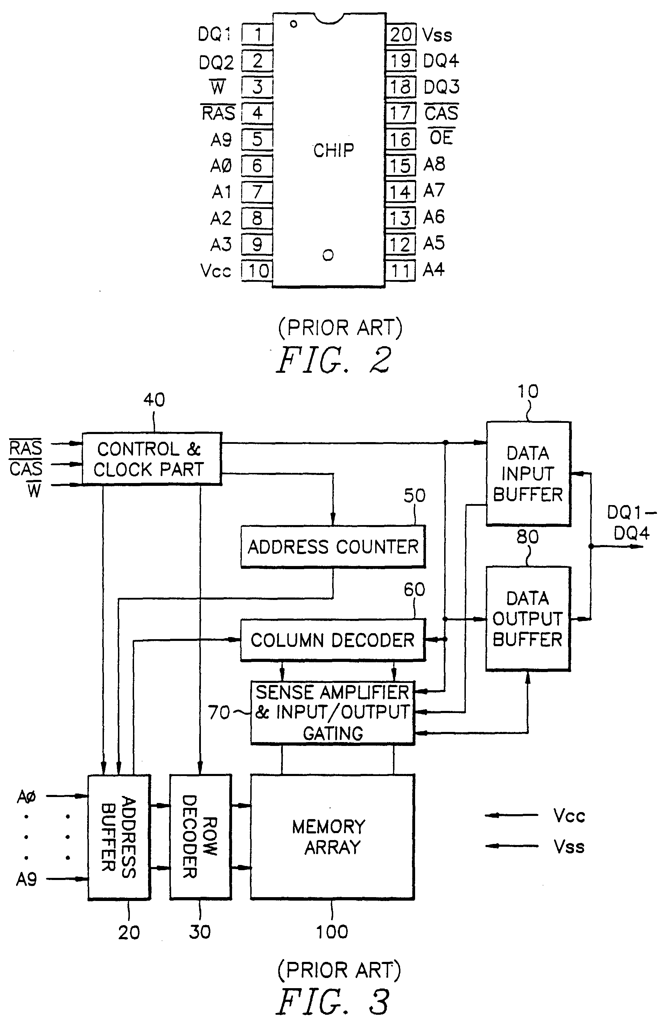

Figure 2 of the accompanying diagrammatic drawings is a diagram showing the connection of pins of Figure 1. A row address strobe signal $\overline{RAS}$ and a column address strobe signal $\overline{CAS}$ are applied with a signal of a TTL (transistor-transistor logic circuit) level controlled by the CPU of the system. At this time, it should be noted that the row address strobe signal $\overline{RAS}$ is connected to only one pin.

Figure 3 of the accompanying diagrammatic drawings is a block diagram illustrating a conventional data access operation. In the construction of the DRAM shown in Figure 1, a number of sub-arrays having a number of accessible memory cells with multiple rows and columns are provided depending on the integration degree of the chip. In Figure 3, a memory array 100 includes one sub-array or more, and in the case of a 4 Mega DRAM, 16 Mega DRAM or more highly integrated semiconductor memory device, usually a plurality of sub-arrays are arranged. In addition, a sense amplifier and a data line, etc. are separately provided and simultaneously a buffer for generating data to the exterior of the chip is provided. An operational characteristic of Figure 3 is described by way of an example of a nibble mode in an operating mode of the DRAM. The nibble mode means an operating cycle achieved by a desire to perform a page mode cycle at high speed in the operating mode of the DRAM. In the page mode, a column address is not applied from the exterior, but incremented in the interior of the DRAM device in the page mode.

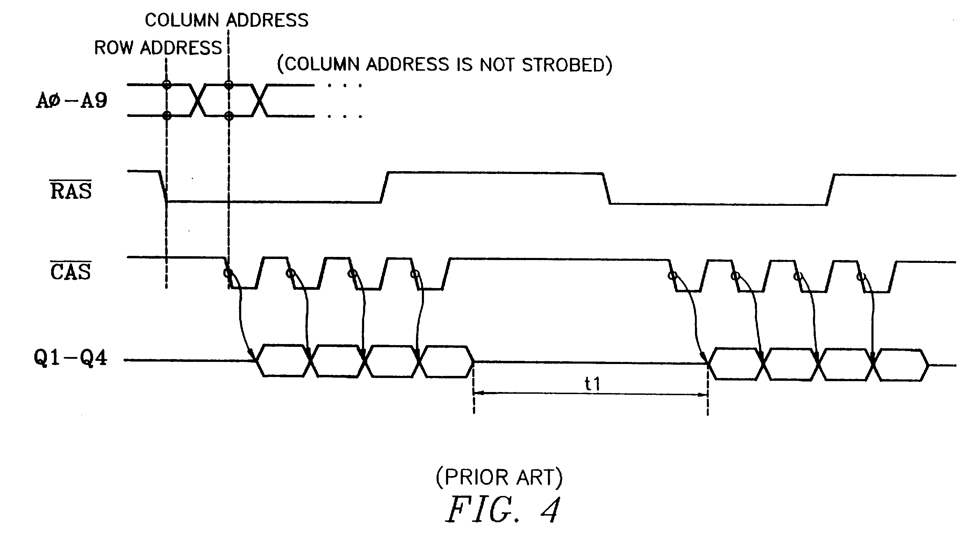

An example of an operation during the nibble mode is shown in Figure 4 of the accompanying diagrammatic drawings. The nibble mode is identical to the page mode except that a column address is not strobed, and the parts which are not strobed can be repeated at high speed. In the case of 1M DRAM, an accessible memory cell with the nibble mode cycle comprises data of 4 bits. In Figure 3, one row address strobe signal $\overline{RAS}$, one column address strobe signal $\overline{CAS}$, and a number of addresses A0 to A9 control the access of data. If the row address strobe signal $\overline{RAS}$ is activated to logic "low" level to enable the chip, the number of sub-arrays are activated, and then, data stored in the memory cell is generated to the exterior of the chip by a series of active cycles. On the other hand, in order to generate new data by a new row address strobe signal, the row address strobe signal $\overline{RAS}$ should be set to logic "high" level. Therefore, a data output chain is reset and an interval t1 exists as shown in Figure 4. Thereafter, the above-mentioned process is repeated by the new row address strobe signal $\overline{RAS}$ of logic "low" level. Thus, data of 4 bits is produced in response to the column address strobe signal $\overline{RAS}$ of logic "low" level. While the row address strobe signal $\overline{RAS}$ is reset, that is, the signal $\overline{RAS}$ is precharged, output data is in a "don't care" state at the interval t1, and after the signal $\overline{RAS}$ is activated, data of 4 bits is produced. In order to improve the performance of the system, a method for increasing an access speed of the DRAM, or another method for providing more random data during a given time should be proposed. However, the method for increasing the access speed has limitations in a given process and design techniques, and in view of the speed of the CPU, the access speed of data is too slow. Further, in the nibble mode, if a cycle time of the column address strobe signal $\overline{CAS}$ is 15ns and that of the row address strobe signal $\overline{RAS}$ is 120ns (in this case, a precharge time of the row address strobe signal $\overline{RAS}$ becomes 60ns), data of 4 bits is produced during 60ns and during the remaining 60ns of the interval t1, no data can be generated. Consequently, since data can not be generated during a precharge cycle, the increase of the access speed of data has limitations.

DATABUS, No. 2, Feb. 1985 describes a Dynamic Random Access Memory consisting of two memory array groups. Input address lines are multiplexed in an input multiplexer and applied to the two memory array groups. The data outputs from the memory array groups are recombined in an output multiplexer. The memory array groups are read alternately and refreshed during the period when their respective $\overline{RAS}$ signals are

inactive. Thus, the memory includes two memory array groups which are alternately accessed and each of which is refreshed during the active cycle of the other. The memory works adequately even if the timings of the $\overline{RAS}$ signals are mismatched and this is achieved by using two column address signals, $\overline{CAS1}$ and $\overline{CAS2}$. Each is associated with a respective memory array group and a respective $\overline{RAS}$ signal. In addition, the column address strobe signals are cycled after an initial enable interval to generate in series four bits of data which are shifted into a shift register in series (FIG. 4).

EDN Electrical Design News, vol. 34, no.8 describes a DRAM refresh process in which the refresh takes place during the inactive cycle of $\overline{RAS}$.

It is an aim of preferred embodiments of the present invention to provide a DRAM operated in response to a high speed system clock supplied from the exterior.

It is another aim to provide a DRAM capable of successively generating data produced from different memory cell arrays from each other in response to a high speed system clock supplied from the exterior during one data access cycle.

It is a further aim to provide a DRAM capable of successively generating data produced from one memory cell array, and data produced from another memory cell array precharged when the memory cell array is in an active state and activated when the memory cell array is in a precharge state in response to a high speed system clock supplied from the exterior during one data access cycle.

According to one aspect of the present invention, there is provided a dynamic random access memory comprising:

a number of memory array groups each having a plurality of memory cells in a row and column matrix form;
an equal number of row address strobe signal input terminals for receiving respective row address strobe signals, each row address strobe signal input terminal being associated with a respective memory array group;
a clock signal input terminal for receiving an external clock signal;
means for sequentially accessing the memory array groups in response to sequential activation of the respective row address strobe signals and activation of a column address strobe signal so that each access of each memory array group provides a plurality of bits of data in parallel;
means for latching the said plurality of bits of data in parallel; and
means for precharging bit lines of the memory array groups corresponding to inactive row address strobe signals.

**characterised in that:**

the memory includes a single column address strobe signal input terminal for receiving a single column address strobe signal and associated with all the memory array groups; and
the means for sequentially accessing the memory array groups is adapted to do so for each memory array group in response to activation of the single column address strobe signal.

Preferably, the means for latching the said plurality of bits further comprises means for reproducing them in series in response to the external clock signal.

Preferably, the means for latching and reproducing the said plurality of bits of data comprises a shift register.

For a better understanding of the invention, and to show how the same may be carried into effect, reference will now be made, by way of example, to Figures 5 to 10 of the accompanying diagrammatic drawings, in which:

Figure 5 is a block diagram illustrating one example of a data access operation according to the present invention;

Figure 6 is a diagram illustrating one example of the connection of pins of a DRAM according to the present invention;

Figures 7A to 7D are block diagrams illustrating control signal of Figure 5;

Figures 8A and 8B are diagrams illustrating the arrangement of sub-arrays;

Figure 9 is a circuit diagram illustrating a data read route of Figure 5; and

Figure 10 is a timing chart of a data access operation of Figure 5.

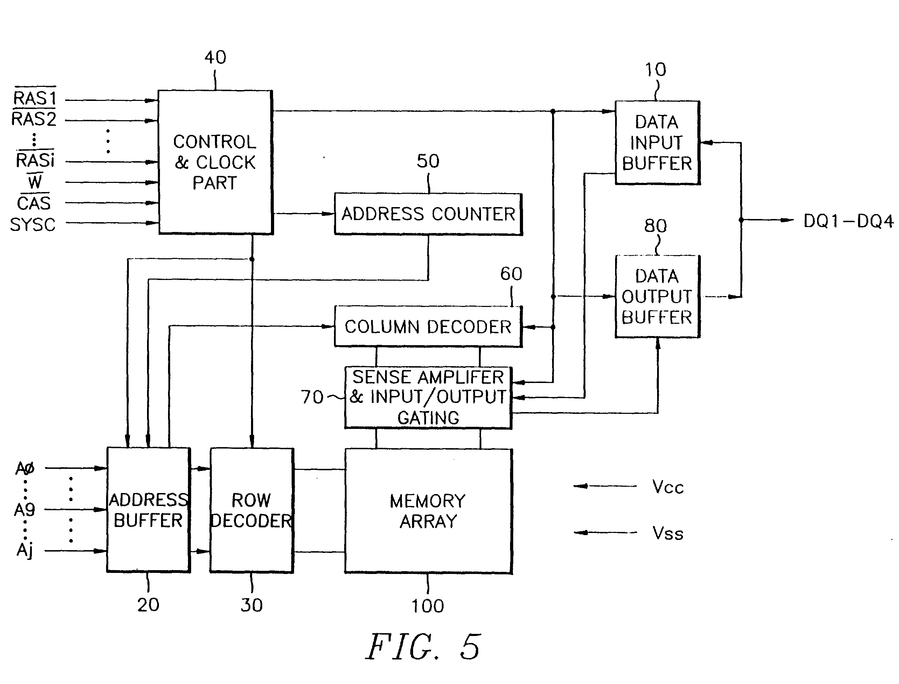

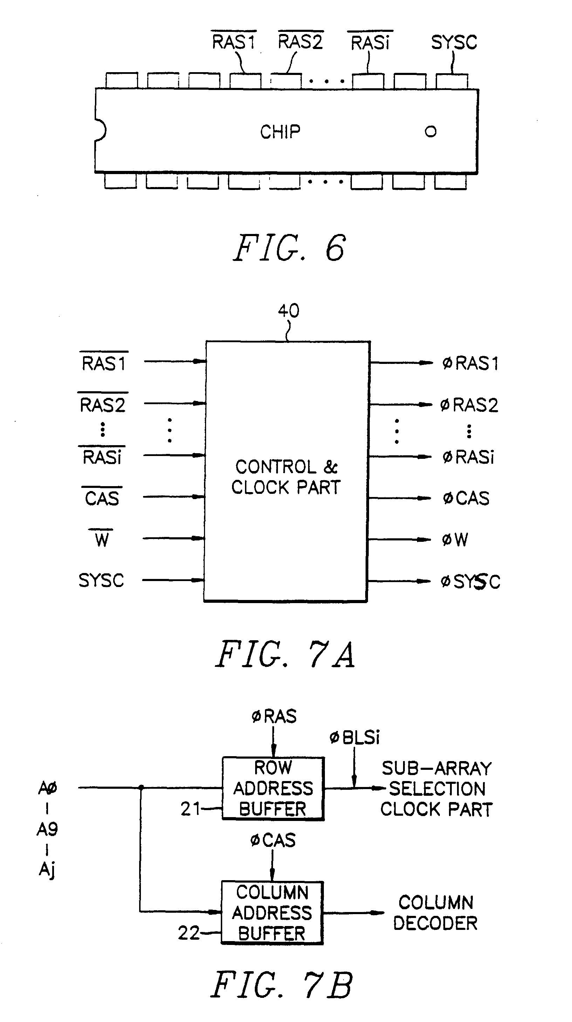

There is a tendency in highly integrated semiconductor memory devices for the number of pins included in one chip to be increased as the degree of integration of a semiconductor memory device is improved. It should be noted that, as the integration degree is improved, embodiments of DRAMs in accordance with the present invention can be effectively operated. Furthermore, the number of external row address strobe signals and pins as input terminals corresponding thereto is determined by the arrangement of a memory array group included in one chip. The construction of Figure 5 is different from that of Figure 3 in that a plurality of row address strobe signals $\overline{RAS1}$ to $\overline{RASi}$ and a system clock SYSC supplied from the system are applied to a control & clock part 40. In Figure 6, the connection of pins in Figure 5 is shown. The number of pins included in a semiconductor memory device is more and more increased according to the increased integration degree, and therefore, the number of addresses A0 to Aj may be increased. Hence, the pins for receiving the row address strobe signals $\overline{RAS1}$ to $\overline{RASi}$ respectively and another pin for receiving the system clock SYSC should be provided.

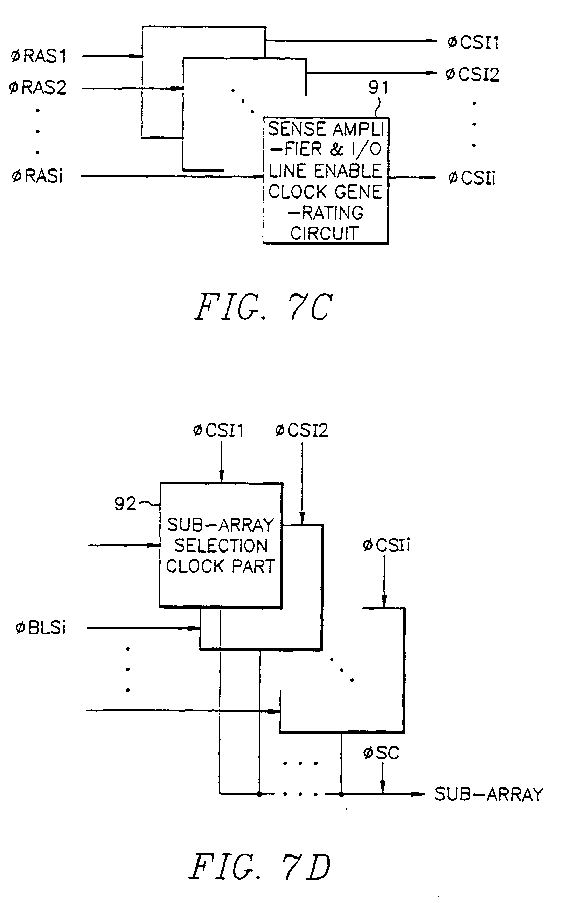

Control signals of the control & clock part 40 of Figure 5 are indicated in Figure 7A. The row address strobe signals $\overline{RAS1}$ to $\overline{RASi}$ supplied from the exterior of the chip are converted into signals $\phi RAS1$ to $\phi RASi$ respectively as internal signals, and the system clock SYSC as an external signal is converted to a system clock $\phi SYSC$ as an internal signal. An address buffer 20 of Figure 5 includes row and column address buffers 21 and 22 as shown in Figure 7B. The addresses A0 to Aj are supplied to the row and column address buffers 21 and 22 respectively. The row address buffer 21 is enabled when any one of the row address strobe signals $\overline{RAS1}$ to $\overline{RASi}$ is activated, and an output signal thereof is a signal $\phi BLSi$ for selecting a desired sub-array. In the preferred embodiment, a sub-array drive clock generating device for driving a desired sub-array is required and simultaneously a control device for driving the sub-array drive clock generating device is necessitated as shown in Figure 7C. The internal row address strobe signals $\phi RAS1$ to $\phi RASi$ generated from the control & clock part 40 of Figure 7A are applied to a sense amplifier & input/output (I/O) line enable clock generating circuit 91. The number of the sense amplifier & input/output (I/O) line enable generating circuits is determined by the number of the internal row address strobe signals $\phi RAS1$ to $\phi RASi$, that is, by the number of sub-array groups. Output signals $\phi CSI1$ to $\phi CSIi$ of each sense amplifier & input/output (I/O) line enable clock generating circuit are supplied to sub-array select clock parts to generate a given sub-array select clock $\phi SC$ as indicated in Figure 7D. In more detail, the sub-array select clock part 92 receives the block select signal $\phi BLSi$ generated from the row address buffer 21 of Figure 7B and the output signals $\phi CSI1$ to $\phi CSIi$ generated from the sense amplifier & input/output (I/O) line enable clock generating circuit 91, to produce the sub-array select clock $\phi SC$. It will be readily appreciated that the number of sub-array select clock parts is determined by the number of sub-array groups. The sub-array select clock $\phi SC$ is a signal for driving a sense amplifier included in a selected sub-array, which will be described later on. Further, one sub-array select clock part should have a plurality of sub-array select clock circuits and the number thereof is determined by the number of sub-arrays in one sub-array group.

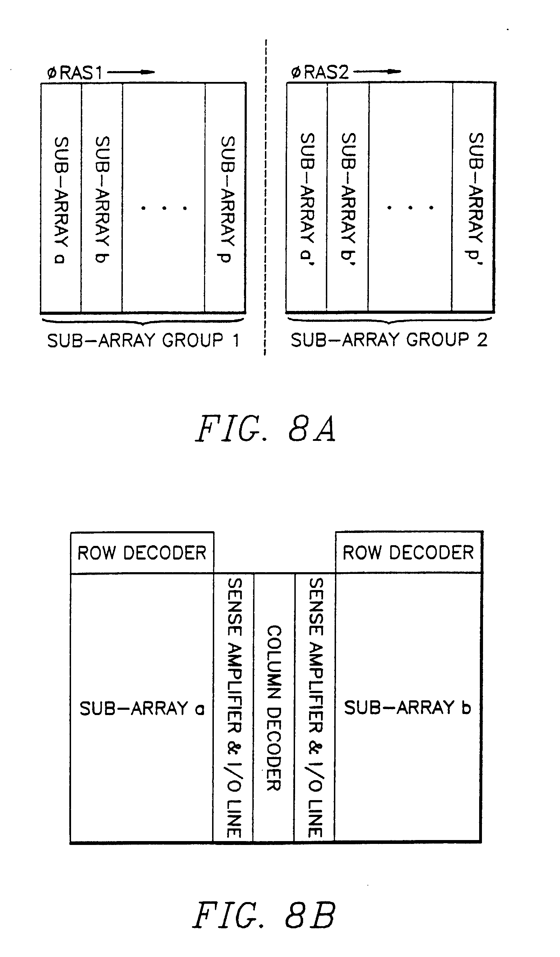

In the case that the sub-array in the memory array is arranged with two groups, an example of a data access operating characteristic will be described hereinafter. In this case, since two row address strobe signals should be applied, two pins for receiving the two row address strobe signals are required. The arrangement of two sub-array groups is shown in Figure 8A.

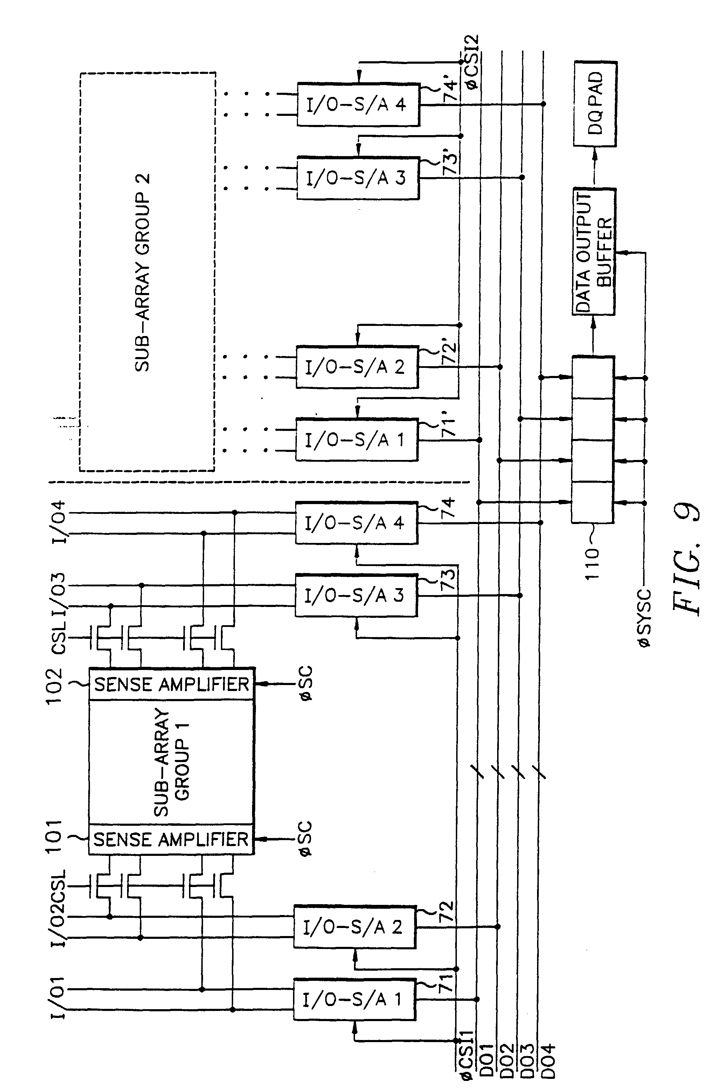

One sub-array group has a plurality of sub-arrays; in some cases, one sub-array group may have one sub-array. In the preferred embodiment, two row address strobe signals $\overline{RAS1}$ and $\overline{RAS2}$ activate or precharge two sub-array groups. The configuration of sub-arrays adjacent to each other is shown in Figure 8B. Figure 9 is a circuit diagram showing a data read routine in each sub-array of Figure 8A. An example of a reading operation of data in a given sub-array will now be described.

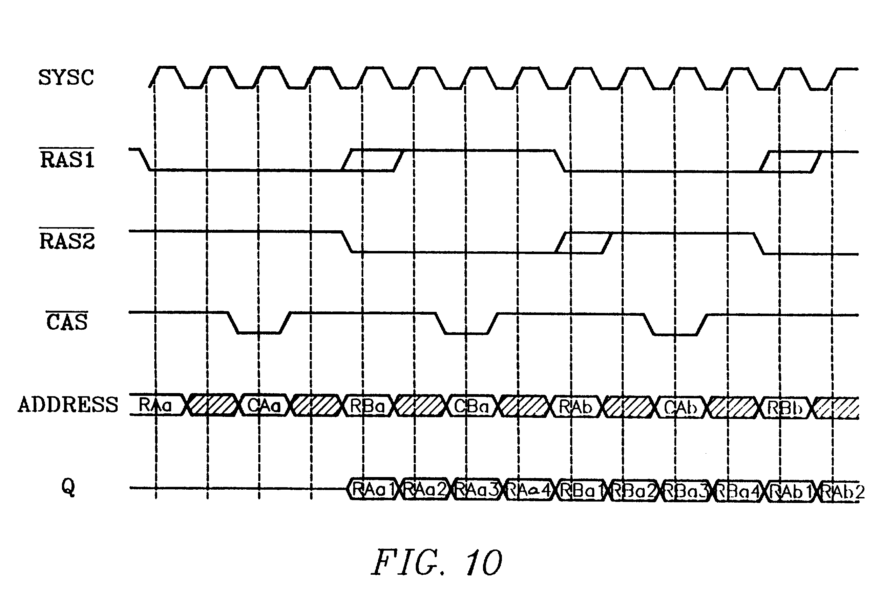

If the row address strobe signal $\overline{RAS1}$ synchronized with the system clock SYSC is activated to logic "low" level, a given sub-array in a sub-array group 1 is activated through the routine shown in Figures 7B to 7D to generate data. In this case, the sub-array select clock $\phi SC$ of Figure 7D enables sense amplifiers 101 and 102 in each sub-array of the sub-array group 1, and the data in the selected sub-array is connected to each input/output (I/O) line. Moreover, the data is supplied to a shift register part 110 for sequentially producing the data through input/output & sense amplifiers (I/O-S/A) 71 to 74 enabled by the signal $\phi CSI1$ generated from the sense amplifier & input/output (I/O) line enable clock generating circuit of Figure 7C. The data stored in the shift register part 110 is synchronized with the system clock $\phi SYSC$ and successively produced. Next, the row address strobe signal $\overline{RAS1}$ is set to logic "high" level, then the row address strobe signal $\overline{RAS2}$ synchronized with the system clock SYSC is activated to logic "low" level while the sub-array activated in the sub-array group 1 is precharged, and a given sub-array in a sub-array group 2 is activated to generate given data through the routine shown in Figures 7B to 7D. At this time, the sub-array select clock $\phi SC$ of Figure 7D enables a sense amplifier in each sub-array of the sub-array group 2, and then, data in the selected sub-array is connected to each input/output (I/O) line. Furthermore, each data is supplied to the shift register part 110 through the input/output & sense amplifiers (I/O-S/A) 71' to 74' enabled by the signal $\phi CSI2$ generated from the sense amplifier & input/output (I/O) line enable clock generating circuit of Figure 7C. Therefore, data stored in the shift register part 110 is synchronized with the system clock $\phi SYSC$ and is successively generated. Thus, data of different sub-array groups are successively produced during one data access cycle as shown in Figure 10.

At this time, a data output time of one bit corresponds to one pulse period of the system clock. For example, if the cycle time of the row address strobe signal $\overline{RAS1}$ is 120ns (In this case, a precharge time of the row address strobe signal $\overline{RAS1}$ becomes 60ns), data of 4 bits is generated during the data access time of 60ns. Thereafter, further data of 4 bits is sequentially generated, since the row address strobe signal $\overline{RAS2}$ is activated while the row address strobe signal $\overline{RAS1}$ is precharged during the precharge time of 60ns thereof. Thus, the row address strobe signals $\overline{RAS1}$ and $\overline{RAS2}$ have an alternative data access time with a time interval of a given level. Therefore, the rate of the data access during a unit time is increased by two times in comparison with that of Figure 3. The data access operation is continuously accomplished while the system clock SYSC is applied. In the timing chart of Figure 10, the row address strobe signal $\overline{RAS2}$ falls at a rising point of the row address strobe signal $\overline{RAS1}$. However, since the system clock SYSC is continuously applied, even if the row address strobe signal $\overline{RAS2}$ falls at a delayed point by a given level in comparison with the rising point of the row address strobe signal $\overline{RAS1}$, the same result can be obtained.

As described above, even if the data access time is predetermined, a large number of random data are achieved by supplying a plurality of row address strobe signals, and thus the data access time becomes faster and system performance can be greatly improved.

**Claims**

1.   A dynamic random access memory comprising:

   a number of memory array groups each having a plurality of memory cells in a row and column matrix form;
   an equal number of row address strobe signal input terminals for receiving respective row address strobe signals, each row address strobe signal input terminal being associated with a respective memory array group;
   a clock signal input terminal for receiving an external clock signal;
   means for sequentially accessing the memory array groups in response to sequential activation of the respective row address strobe signals and activation of a column address strobe signal so that each access of each memory array group provides a plurality of bits of data in parallel;
   means for latching said plurality of bits of data in parallel; and
   means for precharging bit lines of the memory array groups corresponding to inactive row address strobe signals.

   **characterised in that:**

   the memory includes a single column address strobe signal input terminal for receiving said column address strobe signal as a single column address strobe signal and associated with all the memory array groups; and
   the means for sequentially accessing the memory array groups is adapted to do so for each memory array group in response to activation of the single column address strobe signal.

2.   A memory according to claim 1 in which the means for latching the said plurality of bits further comprises means for reproducing them in series in response to the external clock signal.

3.   A dynamic random access memory according to claim 2 in which the means for latching and reproducing the said plurality of bits of data comprises a shift register.

**Patentansprüche**

1.   Dynamischer Schreib/Lese-Speicher, welcher umfaßt:

   eine Anzahl von Speicheranordnungs-Gruppen mit jeweils einer Vielzahl von Speicherzellen in einer Zeilen- und Spalten-Matrixform;
   einer gleichen Zahl von Zeilenadreß-Übernahmesignal-Eingangsklemmen zum Aufnehmen jeweiliger Zeilenadreß-Ünbemahmesignale, von denen jede Zeilenadreß-Übernahmesignal-Eingangsklemme einer jeweiligen Speicheranordnungs-Gruppe zugeordnet ist:
   eine Taktsignal-Eingangsklemme zum Aufnehmen eines externen Taktsignals;
   Mittel zum sequentiellen Zugreifen auf die Speicheranordnungs-Gruppen in Reaktion auf sequentielles Aktivieren der jeweiligen Zeilenadreß-Übemahmesignale und sequentielles Aktivieren eines Spaltenadreß-Übemahmesignals, so daß jeder Zugriff auf jede Speicheranordnungs-Gruppe eine Vielzahl von parallelen Datenbits ergibt;
   Mittel zum parallelen Zwischenspeichem der Vielzahl von Datenbits; und
   Mittel zum Vor-Laden von Bitzeilen der inaktiven Zeilenadreß-Übernahmesignalen entsprechenden Speicheranordnungs-Gruppen:

   **dadurch gekennzeichnet, daß**

   der Speicher eine Einzelspaltenadreß-Übernahmesignal-Eingangsklemme zum Aufnehmen des Spaltenadreß-Übernahmesignals als ein Einzelspaltenadreß-Übemahmesignal und allen Speicheranordnungs-Gruppen zugeordnet enthält; und
   das Mittel zum sequentiellem Zugriff auf die Speicheranordnungs-Gruppen ausgelegt ist, dies bei jeder Speicheranordnungs-Gruppe in Reaktion auf das Einzelspaltenadreß-Übemahmesignal zu tun.

2.   Speicher nach Anspruch 1, das Mittel zum Zwischenspeichem der genannten Vielzahl von Bits Mittel zur Wiedergabe derselben in Reihe in Reaktion auf das externe Taktsignal umfaßt.

**3.** Dynamischer Schreib/Lese-Speicher nach Anspruch 2, bei dem das Mittel zum Zwischenspeichern und Wiedergeben der Vielzahl von Bits ein Schieberegister umfaßt.

## Revendications

**1.** Mémoire vive dynamique comprenant :

un certain nombre de groupes de réseaux de mémoire comportant chacun une pluralité de cellules de mémoire sous une forme de matrice à rangées et colonnes ;
un nombre égal de bornes d'entrée de signal d'échantillonnage d'adresse de rangée pour recevoir des signaux d'échantillonnage d'adresse de rangée respectifs, chaque borne d'entrée de signal d'échantillonnage d'adresse de rangée étant associée à un groupe de réseaux de mémoire respectif ;
une borne d'entrée de signal d'horloge pour recevoir un signal d'horloge externe ;
des moyens pour accéder en séquence aux groupes de réseaux de mémoire en réponse à l'activation séquentielle des signaux d'échantillonnage d'adresse de rangée respectifs et à l'activation d'un signal d'échantillonnage d'adresse de colonne de telle sorte que chaque accès de chaque groupe de réseaux de mémoire délivre une pluralité de bits de données en parallèle ;
des moyens pour verrouiller ladite pluralité de bits de données en parallèle ; et
des moyens pour précharger des lignes de bits des groupes de réseaux de mémoire correspondant à des signaux d'échantillonnage d'adresse de rangée inactifs,

caractérisée en ce que :

la mémoire comprend une borne d'entrée de signal d'échantillonnage d'adresse de colonne unique pour recevoir ledit signal d'échantillonnage d'adresse de colonne sous la forme d'un signal d'échantillonnage d'adresse de colonne unique, et associée à tous les groupes de réseaux de mémoire ; et
les moyens pour accéder en séquence aux groupes de réseaux de mémoire sont adaptés pour réaliser cela pour chaque groupe de réseaux de mémoire en réponse à l'activation du signal d'échantillonnage d'adresse de colonne unique.

**2.** Mémoire selon la revendication 1, dans laquelle les moyens pour verrouiller ladite pluralité de bits comprennent de plus des moyens pour les reproduire en série en réponse au signal d'horloge externe.

**3.** Mémoire vive dynamique selon la revendication 2, dans laquelle les moyens pour verrouiller et reproduire ladite pluralité de bits de données comprennent un registre à décalage.

EP 0 553 547 B1

VCC A3 A2 A1 A0 RAS W DQ2 DQ1

ADDRESS BUFFER & INPUT/OUTPUT CONTROL CIRCUIT

COLUMN DECODER

SENSE AMPLIFIER

ROW DECODER

CLOCK CHAIN

ROW DECODER

COLUMN DECODER

ADDRESS BUFFER & INPUT/OUTPUT CONTROL CIRCUIT

A4 A5 A6 A7 A8 A9 OE CAS DQ3 DQ4 VSS

(PRIOR ART)

*FIG. 1*

DQ1 — |1|       |20| — Vss
DQ2 — |2|       |19| — DQ4
$\overline{W}$ — |3|       |18| — DQ3
$\overline{RAS}$ — |4|       |17| — $\overline{CAS}$
A9 — |5|    CHIP    |16| — $\overline{OE}$
AØ — |6|       |15| — A8
A1 — |7|       |14| — A7
A2 — |8|       |13| — A6
A3 — |9|       |12| — A5
Vcc — |10|       |11| — A4

(PRIOR ART)

*FIG. 2*

(PRIOR ART)

*FIG. 3*

COLUMN ADDRESS

ROW ADDRESS

(COLUMN ADDRESS IS NOT STROBED)

A∅−A9

$\overline{RAS}$

$\overline{CAS}$

Q1−Q4

t1

(PRIOR ART)

*FIG. 4*

FIG. 5

$\overline{RAS1}$  $\overline{RAS2}$  $\overline{RASi}$  SYSC

CHIP  O

## FIG. 6

40

$\overline{RAS1}$ →

$\overline{RAS2}$ →

$\overline{RASi}$ →

$\overline{CAS}$ →

$\overline{W}$ →

SYSC →

CONTROL &
CLOCK PART

→ øRAS1

→ øRAS2

→ øRASi

→ øCAS

→ øW

→ øSYSC

## FIG. 7A

øRAS    øBLSi

A0
|
A9
|
Aj

ROW
ADDRESS
BUFFER
21

SUB-ARRAY
SELECTION
CLOCK PART

øCAS

COLUMN
ADDRESS
BUFFER
22

COLUMN
DECODER

## FIG. 7B

øRAS1

øRAS2

øRASi

91

SENSE AMPLI
-FIER & I/O
LINE ENABLE
CLOCK GENE
-RATING
CIRCUIT

øCSI1

øCSI2

øCSIi

## FIG. 7C

øCSI1     øCSI2

92

SUB-ARRAY
SELECTION
CLOCK PART

øCSIi

øBLSi

øSC

SUB-ARRAY

## FIG. 7D

12

∅RAS1 ⟶

| SUB-ARRAY a | SUB-ARRAY b | . . . | SUB-ARRAY p |

∅RAS2 ⟶

| SUB-ARRAY a' | SUB-ARRAY b' | . . . | SUB-ARRAY p' |

SUB-ARRAY GROUP 1     SUB-ARRAY GROUP 2

*FIG. 8A*

| ROW DECODER | | | | ROW DECODER |
| SUB-ARRAY a | SENSE AMPLIFIER & I/O LINE | COLUMN DECODER | SENSE AMPLIFIER & I/O LINE | SUB-ARRAY b |

*FIG. 8B*

FIG. 9

*FIG. 10*